# EUROPÄISCHE PATENTSCHRIFT

(11) **EP 0 313 722 B1**
(45) Veröffentlichungstag und Bekanntmachung des Hinweises auf die Patenterteilung: **04.08.1993**
(21) Anmeldenummer: 88105063.7
(22) Anmeldetag: 29.03.1988
(51) Int. Cl.: H01L 27/02, H01L 29/78

(54) **Schutzanordnung für MOS-Schaltungen**
Protection arrangement for MOS circuits
Arrangement de protection pour circuits MOS

(30) Priorität: 29.10.1987 EP 87115862
(43) Veröffentlichungstag der Anmeldung: 03.05.1989
(73) Patentinhaber: Deutsche ITT Industries GmbH, 79108 Freiburg (DE)
(72) Erfinder: Theus, Ulrich, Dr.-Ing., D-7803 Gundelfingen (DE); Giebel, Burkhard, Dipl.-Ing., D-7819 Denzlingen (DE)

(56) Entgegenhaltungen:
- EP-A- 0 260 125
- WO-A-86/06213
- GB-A- 2 152 283
- US-A- 4 509 067
- PROCEEDINGS OF THE 1980 ELECTRICAL OVERSTRESS/ELECTROSTATIC DISCHARGE SYMPOSIUM, 1980, Seiten 73-80; J.K. KELLER: "Protection of MOS integrated circuits from destruction by electrostatic discharge"

## Beschreibung

Die Erfindung betrifft Schutzanordnungen für MOS-Schaltungen (= integrierte Feldeffekt-Transistor-Schaltungen mit isoliertem Gate), die zwischen einem auf einer deren Substrat bedeckenden Isolierschicht angeordneten Pad und einem zu schützenden Transistor liegt und die einen den Pad mit einem Anschluß des Transistors verbindenden, in das Substrat eingelassenen Widerstand des entgegengesetzten, anderen Leitungstyps enthält.

Derartige Schutzanordnungen sind seit der Anfangszeit der integrierten MOS-Schaltungen üblich und dienen dem Schutz der empfindlichen Gate-Isolationsschicht gegen statische und/oder dynamische Überspannungen, die über die äußeren Anschlüsse einer gekapselten integrierten Schaltung zum Pad und somit zum Gate des damit gekoppelten Transistors gelangen und, wenn die Durchschlagfeldstärke der Gate-Isolationsschicht überschritten wird, diese zerstören. Zum Stand der Technik wird z.B. auf die DE-B 16 39 255 verwiesen, von der der eingangs zitierte Oberbegriff des Anspruchs 1 ausgeht. Gegebenenfalls kann außerdem am Verbindungspunkt von Widerstand und zu schützendem Transistor ein Ableittransistor angeschlossen sein.

Aus der EP-0 260 125 A2 ist eine Schutzschaltung bekannt, die den Pad über einen Transistor mit einer ersten Versorgungsspannung und über eine Diode mit einer zweiten Versorgungsspannung verbindet.

Zur Bildung dieser beiden Elemente wird eine den Randbereich des Pad umschließende Zone, mit einem von der Dotierung des Substrats unterschiedlichen ersten Zone gebildet, die in einem Teilbereich von einer zweiten Zone gleicher Dotierung begleitet wird, die mit der ersten Versorgungsspannung verbunden ist und die in einem weiteren Teilbereich von einer Zone mit entgegengesetzter Dotierung begleitet wird, die mit der zweiten Versorgungsspannung verbunden ist.

Wie sich gezeigt hat, bedarf es jedoch nicht nur der Anordnung eines Widerstandes zwischen dem Pad und dem zu schützenden Transistor sowie des erwähnten Ableittransistors, sondern es sind auch weitere Maßnahmen erforderlich, um den Schutzzweck insbesondere dann zu erfüllen, wenn die integrierten Schaltungen den heute üblichen Standard-Test bestehen sollen, bei dem ein Spannungsimpuls in der Größenordnung von 2 kV von einem Kondensator aus über einen Vorwiderstand an einen Pad gelegt wird, der einen Impulsstrom in der Größenordnung von 1 A hervorrufen kann.

Die Aufgabe der in den Ansprüchen gekennzeichneten Erfindung besteht darin, die vorbeschriebene Schutzanordnung so zu verbessern, daß sie mindestens bei den angegebenen Testwerten die mit dem Pad einer integrierten MOS-Schaltung gekoppelten Transistoren sicher schützt.

Durch die erfindungsgemäße Ausbildung der Schutzanordnung wird ein sicherer Schutz über die genannten Testbedingungen hinaus gewährleistet. Dies wird ohne zusätzliche Verfahrensschritte bei der Herstellung der integrierten MOS-Schaltung erreicht, d.h. ausschließlich dadurch, daß nur solche zusätzlichen Zonen und Gebiete vorgesehen werden, die mit Verfahrensschritten erzeugt werden können, die zur Herstellung der integrierten MOS-Schaltung auch so schon erforderlich sind.

Die Erfindung wird nun anhand der Figuren näher erläutert.
Fig. 1 zeigt in Draufsicht stark schematisiert ein bevorzugtes Ausführungsbeispiel einer Schutzanordnung,
Fig. 2 zeigt den Querschnitt der Anordnung nach Fig. 1 entlang der Schnittlinie A-A sowie ein elektrisches Ersatzschaltbild für den Betrieb dieser Anordnung,
Fig. 3 zeigt in Draufsicht stark schematisiert das Ausführungsbeispiel einer Weiterbildung der Anordnung nach Fig. 1,
Fig. 4 zeigt den Querschnitt der Anordnung nach Fig. 3 entlang der Schnittlinie A-A sowie das der Fig. 2 entsprechende Ersatzschaltbild der Fig. 3, und
Fig. 5 zeigt die stark schematisierte Draufsicht eines Ausführungsbeispiels mit zweifacher Realisierung der Weiterbildung nach Fig. 3.

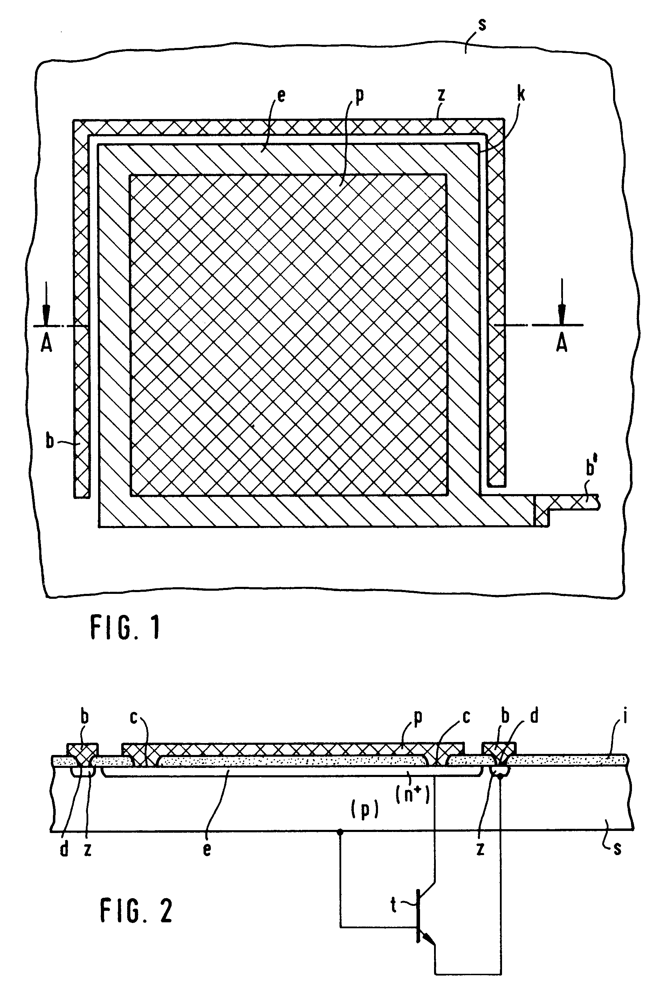

In der stark schematisierten Draufsicht des bevorzugten Ausführungsbeispiels nach Fig. 1 sind wegen der Übersichtlichkeit der Zeichnung der Ableittransistor und der zu schützende Transistor nicht dargestellt. In Fig. 1 ist mit der gekreuzten Schraffur sowohl die im allgemeinen aus einem geeigneten Metall, z.B. Aluminium, bestehende leitende Fläche des Pads p als auch die Leitbahn b veranschaulicht. Mit der einfachen, von links oben nach rechts unten verlaufenden Schrägschraffur ist dagegen die Erweiterungszone e veranschaulicht, durch die der eingangs erwähnte Widerstand zwischen Pad und zu schützendem Transistor realisiert ist.

Bei der Erfindung ist die Erweiterungszone e in das Substrat s der integrierten MOS-Schaltung, das in Fig. 1 durch die weißen Flächen symbolisiert ist, eingelassen, d.h. sie kann durch eines der üblichen Dotierverfahren, wie z.B. Ionenimplantation oder Diffusion aus fester Phase oder der Gasphase, innerhalb des vorgesehenen Bereichs des Substrats s hergestellt werden, wobei die Erweiterungszone e den zum Substrat s entgegengesetzten Leitungstyp hat, d.h. sie ist vom selben Leitungstyp wie die Source- und die Drainzonen der Transistoren der MOS-Schaltung, und sie ist außerdem niederohmig.

Die Flächenform der Erweiterungszone e ist gleich der des Pads p, d.h. also, daß sie z.B. wie in Fig. 1 quadratisch wie der Pad p ist. Die den Pad p zentral tragende Fläche der Erweiterungszone e ist größer als seine Flache und mit ihm niederohmig kontaktiert, was beispielsweise durch eine Vielzahl von am Umfang des Pads p angeordneten kleinflächigen Kontaktierungszonen erreicht werden kann, die jedoch in Fig. 1 der Übersichtlichkeit halber nicht gezeigt sind, jedoch in der Schnittansicht der Fig. 2 beim Bezugszeichen c zu erkennen sind. Nach Fig. 1 ist die Padfläche von einem überall gleich breiten Streifen der Erweiterungszone e umgeben, der in der Draufsicht nach Fig. 1 über den Pad vorsteht. Dies ist jedoch nur an den Seiten des Pads p erforderlich, die von der Zone z begleitet sind, so daß die den Pad p tragende Fläche nicht zentral zur Erweiterungszone e angeordnet zu sein braucht.

Die Erweiterungszone e ist in Fig. 1 entlang drei Seiten von der langgestreckten Zone z minimaler Breite in minimalem Abstand begleitet, die vom gleichen Leitungstyp und gleichen spezifischen Widerstand wie die Erweiterungszone e ist. Die langgestreckte Zone z verläuft also parallel zu den drei Seitenkanten der Erweiterungszone e, so daß sich in Fig. 1 eine etwa 270° Drehwinkel aufweisende Umfassung ergibt.

Über die mit gekreuzter Schraffierung gekennzeichnete Leiterbahn b' in der rechten unteren Ecke der Fig. 1 ist die den Widerstand bildende Erweiterungsfläche e mit einem Eingang des zu schützenden Transistors verbunden.

Mit dem Ausdruck minimale Breite bzw. minimaler Abstand sind diejenigen nicht zu unterschreitenden Abmessungen gemeint, die nach den jeweiligen Design-Rules einer konkreten integrierten Schaltung gerade noch zulässig sind.

Die Oberfläche der langgestreckten Zone z ist, wie bereits erwähnt wurde und durch die Kreuzschraffur veranschaulicht ist, mit der Leitbahn b über ihre gesamte Länge niederohmig kontaktiert, und die Leitbahn b ist mit dem Schaltungsnullpunkt der MOS-Schaltung verbunden. Diese Kontaktierung erfolgt wiederum mittels vieler kleinflächiger Kontaktierungszonen, von denen einige in Fig. 2 bei d zu sehen sind.

In Fig. 2, die die Schnittansicht einer MOS-Schaltung mit p-leitendem Substrat entlang der Linie A-A der Fig. 1 zeigt, sind die durch die geometrische Anordnung der Fig. 1 bedingten Teile der einzelnen Zonen zu sehen, wobei von links beginnend zunächst der in Fig. 1 links verlaufende senkrechte Teil der Zone z mit dem entsprechenden Teil der Leitbahn b gezeigt ist. Anschließend daran ist die unter dem Pad p angeordnete Erweiterungszone e in ihrer gesamten Breite zu sehen, auf deren zentralem Oberflächenteil die Isolierschicht i angeordnet ist, die den Pad p trägt und die an den Stellen c mit ihm kontaktiert ist. Neben dem rechten Ende liegt dann der im rechten Teil der Fig. 1 liegende, nach unten verlaufende Teil der langgestreckten Zone z.

Durch den eingezeichneten Transistor t ist veranschaulicht, daß bei Auftreten einer Überspannung am Pad p, z.B. bei Anlegen der erwähnten Testspannung, das Substrat s als Basis, die Erweiterungszone e als Kollektor und die langgestreckte Zone z als Emitter des Transistors t wirken. Durch die hohe Spannung am Pad p wird der Transistor t bis in das Abbruchgebiet der Kollektor-Emitter-Strecke getrieben, und zwar bis in den rückläufigen Teil der Kollektorstrom/Kollektor-Emitter-Spannungs-Kennlinie. Dadurch wird sowohl die am Pad wirksame Spannung als auch die an ihm umgesetzte Energie stark verringert. Außerdem reicht die in der "Basis" gespeicherte Ladung aus, auch bei abklingendem Strom der Testspannungsquelle die Kollektor-Emitter-Spannung niedrig zu halten.

Durch das Steuern in das Abbruchgebiet entsteht am erwähnten Vorwiderstand der Testanordnung ein Spannungsabfall, der einerseits verhindert, daß an den zu schützenden Transistor eine zerstörende Spannung gelangt, und andererseits die Strombelastung des ggf. vorhandenen Ableittransistors reduziert. Im einzelnen geschieht dies dadurch, daß bei Anlegen des eingangs erwähnten Testsignals die Spannung am Pad p zunächst soweit ansteigt, daß der pn-Übergang zwischen der Erweiterungszone e und dem Substrat s durchbricht und somit das Potential des Substrats soweit anhebt, bis es positiver als die mit dem Schaltungsnullpunkt verbundene langgestreckte Zone z wird. Diese wirkt dann als Emitter des gezeichneten Ersatzschaltbildtransistors t.

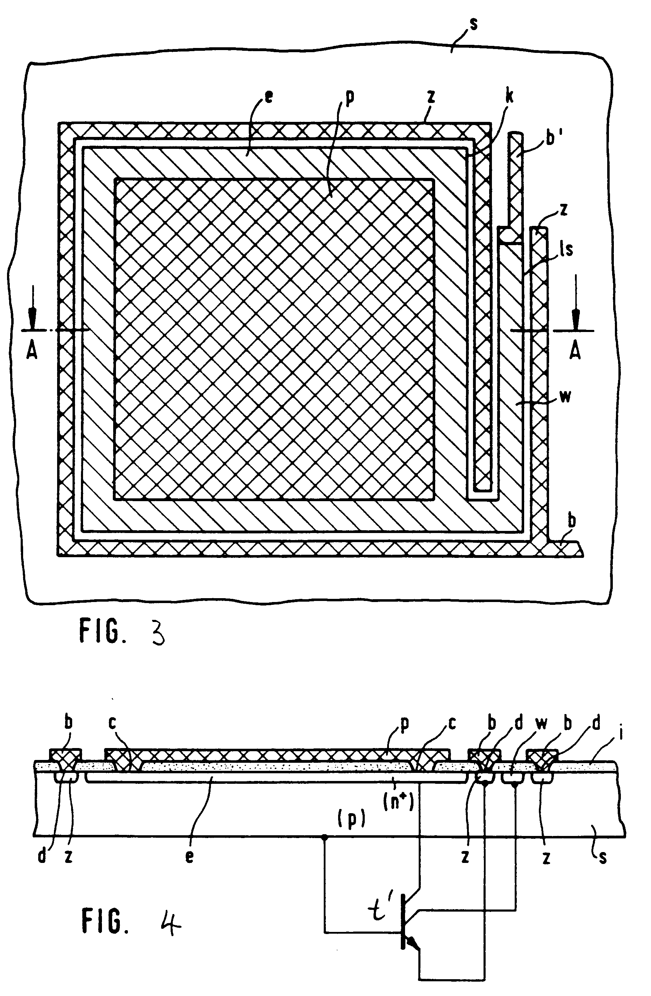

In der stark schematisierten Draufsicht des Ausführungsbeispiels der Weiterbildung nach Fig. 3 sind wegen der Übersichtlichkeit der Zeichnung der Ableittransistor und der zu schützende Transistor wie in Fig. 1 nicht dargestellt. In Fig. 3 ist mit der gekreuzten Schraffur sowohl die im allgemeinen aus einem geeigneten Metall, z.B. Aluminium, bestehende leitende Fläche des Pads p als auch die Leitbahn b veranschaulicht. Mit der einfachen, von links oben nach rechts unten verlaufenden Schrägschraffur sind dagegen die Erweiterungszone e und die Widerstandszone w veranschaulicht, durch die der eingangs erwähnte Widerstand zwischen Pad und zu schützendem Transistor realisiert sind.

Die Widerstandszone w ist in das Substrat s der integrierten MOS-Schaltung, das in Fig. 3 wieder durch die weißen Flächen symbolisiert ist, eingelassen, ist die Fortsetzung der Erweiterungszone e und hat den gleichen Leitungstyp und den gleichen spezifischen Widerstand wie letztere.

Die Widerstandszone w verläuft parallel zu der rechten Seitenkante k der Erweiterungszone e und geht am unteren Ende in die rechte untere Ecke der Erweiterungszone e über. An ihrem oberen Ende ist sie mit der weiteren Leitbahn b′ kontaktiert, die zu einem Anschluß, z.B. zum Gate oder zur Source, des zu schützenden Transistors führt.

Zwischen den beiden einander zugewandten Seitenkanten von Widerstandszone w und Erweiterungszone e setzt sich in Fig. 3 die langgestreckte Zone z von minimaler Breite fort. Zusätzlich zu diesem Teil verläuft die langgestreckte Zone z wie in Fig. 1 parallel zu den anderen Seitenkanten der Erweiterungszone e und auch parallel zu der der Erweiterungszone e abgewandten Seitenkante ls der Widerstandszone w, so daß sich in Fig. 3 eine etwa 400° Drehwinkel aufweisende Rechteckspirale ergibt.

Die Oberfläche der langgestreckten Zone z ist wieder mit der Leitbahn b über ihre gesamte Länge niederohmig kontaktiert, und die Leitbahn b ist mit dem Schaltungsnullpunkt der MOS-Schaltung verbunden. Diese Kontaktierung erfolgt wiederum mittels vieler kleinflächiger Kontaktierungszonen, von denen einige in Fig. 4 bei d zu sehen sind.

Die Fig. 4 , die die Schittansicht einer MOS-Schaltung mit p-leitendem Substrat entlang der Linie A-A der Fig. 3 zeigt, entspricht der Fig. 2. Zusätzlich zu Fig. 2 liegt am rechten Ende noch die Widerstandszone w und der rechte Teil der langgestreckten Zone z. Der Transistor t′ hat somit einen weiteren Kollektor, der von der Widerstandszone w gebildet ist und der in gleicher Weise wie der Kollektor nach Fig. 2 wirkt sowie dessen Wirkung unterstützt.

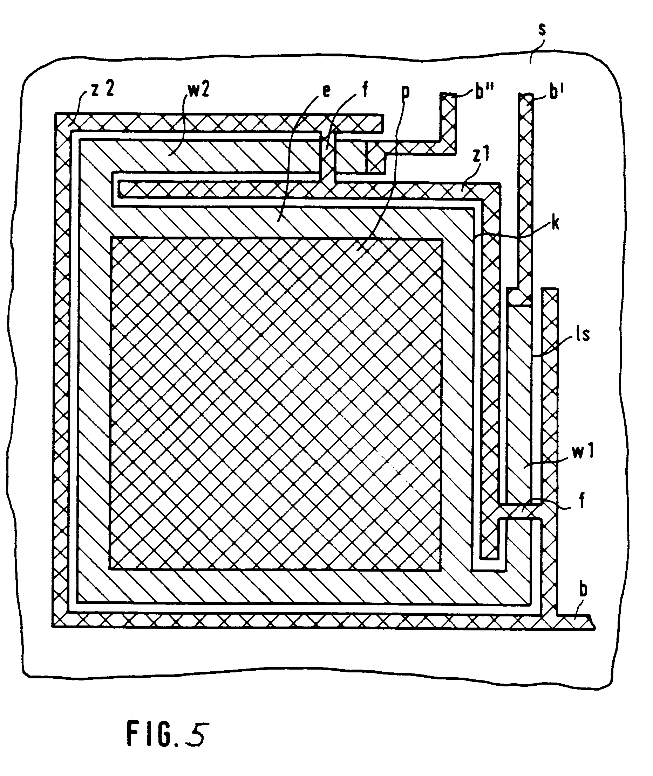

Die Fig. 5 zeigt die zweifache Realisierung der Weiterbildung nach Fig. 3 für den Fall, daß z.B. Gate und Drain des zu schützenden Transistors oder daß z.B. zwei voneinander unabhängige Transistoren durch je eine Schutzanordnung zu schützen sind. Dabei entspricht die Widerstandszone w1 völlig der Widerstandszone w nach Fig. 3, während die Widerstandszone w2 an der den Übergang zur Erweiterungszone e bildenden Ecke gegenüberliegenden Ecke in derselben Weise angeordnet ist. Durch die beiden Widerstandszonen w1, w2 ergeben sich die beiden langgestreckten Teilzonen z1, z2, wobei die erstere L-förmig zwischen den einander zugewandten Seitenkanten der Widerstandszone w1 und der Erweiterungszone e bzw. der Widerstandszone w2 und der Erweiterungszone e angeordnet ist.

Zu den beiden Widerstandszonen w1, w2 gehört also eine einzige Erweiterungszone e, wodurch sich ein kompaktes Layout ergibt.

Die andere langgestreckte Teilzone z2 verläuft wiederum parallel zu den äußeren Seitenkanten der Erweiterungszone e und umgreift auch die von den Seitenkanten der Erweiterungszone abgewandten parallelen Seitenkanten der Widerstandszonen w1, w2. Die Teilzone z2 ist dabei nur eine einen Drehwinkel von etwa 300° aufweisende Rechteckspirale. Die beiden Teilzonen z1, z2 sind durch Leitbahnstege f miteinander verbunden. Jede Widerstandszone w1, w2 führt beispielsweise zu einem anderen Anschluß des zu schützenden Transistors.

Der Widerstand der jeweiligen Widerstandszone w1, w2 wird in bevorzugter Dimensionierung gerade so hochohmig gemacht, daß die Schaltungsfunktion der über die beiden weiteren Leitbahnen b′, b˝ angeschlossen MOS-Schaltung durch seinen zwischen dem Pad und dem "ersten" Transistor der Schaltung liegenden Widerstand gerade noch nicht gestört wird. Ferner hat er bevorzugt eine solche Flächengröße, daß der von einem bei der Testung vorgesehenen Standard-Teststromwert am Widerstand hervorgerufene Spannungsabfall gerade gleich der Abbruchspannung des zwischen der Erweiterungszone e und dem Substrat s vorhandenen pn-Übergangs ist.

Durch die beschriebene Schutzanordnung wird also bei Überspannung am Pad p ein Spannungsabfall längs der Widerstandszone w erzeugt, ohne daß hierzu ein Strom in der weiteren Leitbahn b′ fließt. Dabei ist die Größe und Geschwindigkeit mit der sich der Spannungsabfall aufbaut, ausreichend, um die nachfolgenden Schaltungen vor zerstörenden Überspannungen zu schützen.

Bei dem erwähnten Abbruch ist der Gefahr der Stromeinschnürung, also des sogenannten Second Breakdown, dadurch vorgebeugt, daß die Fläche der Erweiterungszone e, wie oben bereits erläutert wurde, größer ist als die Fläche des Pads p. Dadurch ergibt sich ein Vorwiderstand ausreichender Größe, da der Durchbruch des erwähnten pn-Übergangs immer am Rand zuerst erfolgt.

## Patentansprüche

1. Schutzanordnung für integrierte MOS-Schaltungen (= integrierte Feldeffekttransistor-Schaltungen mit isoliertem Gate), die zwischen einem auf einer deren Substrat (s) bedeckenden Isolierschicht (i) angeordneten Pad (p) und einem zu schützenden Transistor liegt und einen den Pad mit einem Anschluß des Transistors verbindenden, in das Substrat (s) eingelassenen Widerstand des entgegengesetzen, anderen Leitungstyps, enthält,
gekennzeichnet durch folgende Merkmale:
- der Widerstand ist eine Erweiterungszone (e) deren Flächenform gleich der des Pads (p) ist und deren den Pad vorzugsweise zentral, tragende Fläche größer als die Padfläche ist und die sowohl mit der Padfläche als auch mit dem zu schützenden Transistor niederohmig verbunden ist, und
- der Rand der Erweiterungszone (e) ist mindestens teilweise von einer langgestreckten Zone (z, z1, z2) von minimaler Breite in minimalem Abstand begleitet, die
-- vom gleichen Leitungstyp und gleichen spezifischen Widerstand wie die Erweiterungszone (e) ist und
-- an ihrer Oberfläche mittels einer Leitbahn (b) niederohmig kontaktiert ist, die mit dem Schaltungsnullpunkt der MOS-Schaltung verbunden ist.

2. Schutzanordnung nach Anspruch 1 mit einer rechteckigen Erweiterungszone (e), dadurch gekennzeichnet, daß die Erweiterungszone (e) sich in einer in das Substrat (s) eingelassenen, langgestreckten Widerstandszone (w, w1, w2) fortsetzt, die parallel zu mindestens einer Seitenkante (k) der Erweiterungszone (e) verläuft und die von dieser durch die langgestreckte Zone (z, z1, z2) minimaler Breite getrennt ist, die auch parallel zur von der Erweiterungszone abgewandten Längsseite (ls) der Widerstandszone (w, w1, w2) bis zu deren einem Ende verläuft.

3. Schutzanordnung nach Anspruch 2, dadurch gekennzeichnet, daß die Widerstandszone (w, w1, w2) gerade so hochohmig ist, daß die Schaltungsfunktion der MOS-Schaltungen nicht gestört wird, und eine solche Fläche hat, daß der von einem vorgesehenen Teststromwert an der Widerstandszone (w, w1, w2) hervorgerufene Spannungsabfall gleich der Abbruchspannung des zwischen der Erweiterungszone (e) und dem Substrat (s) vorhandenen pn-Übergangs ist.

## Claims

1. A protective arrangement for MOS integrated circuits (= insulated-gate field-effect transistor integrated circuits) which lies between a pad (p) on an insulating layer (i) covering the substrate (s) of the MOS integrated circuit and a transistor to be protected and includes a resistor of the opposite, other conductivity type which is incorporated in the substrate (s) and connects the pad to a terminal of the transistor,
characterized by the following features:
- The resistor is an expansion region (e) whose surface has the same shape as that of the pad (p), and whose area supporting the pad, which is preferably the central area, is greater than the pad area, and which is connected via a low-resistance path both with the pad and with the transistor to be protected;
- the edge of the expansion region (e) is accompanied, at least in part, by an elongate region (z, z1, z2) of preferably minimum width spaced a minimum distance therefrom, which
-- is of the same conductivity type and has the same resistivity as the expansion region (e), and
-- is contacted at its surface by means of a low-resistance interconnection track (b) connected to ground.

2. A protective arrangement according to claim 1 with a rectangular expansion region (e), characterized in that the expansion region (e) continues as an elongate resistance region (w, w1, w2) which is incorporated in the substrate (s), extends parallel to at least one lateral edge (k) of the expansion region (e), and is separated from the latter by the elongate region (z, z1, z2) of minimum width, which also extends parallel to the long side (ls) of the resistance region (w, w1, w2) remote from the expansion region and up to one end of the resistance region (w, w1, w2).

3. A protective arrangement as claimed in claim 2, characterized in that the resistance of the resistance region (w, w1, w2) is just so high as not to interfere with the operation of the MOS circuit, and that the resistance region (w, w1, w2) has such an area that the voltage drop caused across it by a specified test current value is equal to the breakdown voltage of the pn junction between the expansion region (e) and the substrate (s).

## Revendications

1. Dispositif de protection pour circuits intégrés MOS (= circuit intégré à transistors à effet de champ à grille isolée), qui est situé entre un plot (p) disposé sur une couche isolante (i) recouvrant le substrat (s) du dispositif, et un transistor à protéger, et qui comprend une résistance, qui raccorde le plot à une borne du transistor, est insérée dans le substrat (s) et possède l'autre type de conductivité opposé,
caractérisé par les caractéristiques suivantes :
- la résistance est une zone d'extension (e), dont la surface possède une forme identique à celle du plot (p) et dont la surface, qui porte le plot, de préférence en position centrale, est supérieure à la surface du plot, et qui est raccordée selon une liaison à faible valeur ohmique aussi bien à la surface du plot qu'au transistor à protéger, et
- le bord de la zone d'extension (e) est longé au moins partiellement, en en étant séparé par une distance minimale, par une zone allongée (z, z1, z2) qui possède une largeur minimale, qui
-- possède le même type de conductivité et la même résistance spécifique que la zone d'extension (e), et
-- dont la surface est en contact, selon une liaison de faible valeur ohmique, avec une voie conductrice (b), qui est raccordée au point neutre du circuit MOS.

2. Dispositif de protection selon la revendication 1, comportant une zone d'extension rectangulaire (e), caractérisé en ce que la zone d'extension (e) se prolonge par une zone allongée de résistance (w, w1, w2), qui est insérée dans le substrat (s) qui s'étend parallèlement au moins à un bord latéral (k) de la zone d'extension (e) et qui est séparée de ce bord par la zone allongée (z, z1, z2) de largeur minimale, qui est également parallèle au côté longitudinal (1s), tourné à l'opposé de la zone d'extension, de la zone de résistance (w, w1, w2) jusqu'à une extrémité de cette zone.

3. Dispositif de protection selon la revendication 2, caractérisé en ce que les zones de résistance (w, w1, w2) possèdent une valeur ohmique élevée précisément telle que la fonction des circuits MOS n'est pas perturbée, et possède une surface telle que la chute de tension, qui est provoquée par une valeur de courant de test prévue, dans la zone de résistance (w, w1, w2) est égale à la tension de claquage de la jonction pn présente entre la zone d'extension (e) et le substrat (s).
